# EUROPEAN PATENT APPLICATION

(11) **EP 4 738 186 A1**
(43) Date of publication of application: **06.05.2026**
(21) Application number: 24832556.5
(22) Date of filing: 27.06.2024
(51) Int. Cl.: G06K 7/10, G06K 19/07, B60C 23/04, H03M 7/08, H03M 7/12, G06K 19/077, G06K 17/00, G06Q 10/08

(54) **TIRE INFORMATION MANAGEMENT SYSTEM AND TIRE INFORMATION MANAGEMENT METHOD USING SAME**

(30) Priority: 27.06.2023 KR 20230082955; 17.07.2023 KR 20230092643
(71) Applicant: HANKOOK TIRE & TECHNOLOGY CO., LTD, Gyeonggi-do 13494 (KR)
(72) Inventor: SO, Soon-Hong, Daejeon 34127 (KR)
(74) Representative: Zimmermann, Tankred Klaus
(86) International application number: PCT/KR2024/095895
(87) International publication number: WO 2025/005780

(57) **Abstract**

The present invention relates to a tire information management system and a tire information management method using the same, and more specifically, relates to a tire information management system and a tire information management method using the same, which can easily manage tire information according to international standards while also enabling confirmation of tire information even if the tire label is damaged. An embodiment of the present invention to achieve the above-mentioned purpose comprises, in a tire information management system for recording and reading tire information: an electronic device (100) mounted on the tire and having a memory (110) of 96 bits or more for recording tire information; an input device (200) for inputting tire information into the memory (110) of the electronic device (100); a reading device (300) for reading tire information input into the memory (110) of the electronic device (100); wherein the memory (110) stores tire company information, product information, and serial number information.

## Description

### [TECHNICAL FIELD]

The present invention relates to a tire information management system and a tire information management method using the same. More specifically, it relates to a tire information management system and a tire information management method using the same, which can easily manage tire information according to international standards while also enabling the confirmation of tire information even when the tire label is damaged.

The present invention relates to a data reading apparatus for a wireless electronic device for tires and a method for reading its data, and more particularly, to a wireless electronic device data reading apparatus for tires and a data reading method for easily managing tire information by customer.

### [BACKGROUND ART]

An ISO standard for inputting tire IDs has been established and published. This standard represents the tire manufacturer number, product information, and tire serial number using each manufacturer's unique number.

The ISO standard follows the format of GS1, an international private standards organization, and represents the unique numbers in binary form.

Methods have been developed for reading data stored in the memory of an electronic device embedded in a tire to input and read the tire's electronic ID, including a memory with a data storage area containing a reserved field for the tire's serial number and a method for storing the serial number in bit form.

However, because there are characters and numbers in the serial number of a tire, it is necessary to effectively distinguish, encode, and manage such information, but no such technology existed in the prior art.

Korean Patent Publication No. 10-2017-00664, 'Tire Tracking RFID Label', describes an identification label and its incorporation into rubber goods. The label includes an RFID component and can be incorporated into a tire. The label can withstand the relatively harsh conditions associated with vulcanization. It discloses a tire tracking label comprising at least one face layer; optionally, at least one primer layer; at least one adhesive layer; and at least one RFID component.

Korean Patent No. 10-0715864 'Tire Using an RFID Tag' relates to a tire using an RFID tag, wherein the RFID tag is installed on the inner or outer surface of the tire's inner or outer sidewall to attach for identifying tire information, and the content of carbon, a conductive material, is reduced so as not to decrease the RFID recognition rate. It discloses a tire characterized by installing the RFID tag on the tire's sidewall, wherein the tire composition comprises, based on 100 parts by weight of diene rubber, 10 to 70 parts by weight of carbon black and 10 to 70 parts by weight of non-conductive silica.

Michelin's US 9,177,183 B2 describes a method for reading data stored in the memory of an electronic device contained within a tire, a memory including a data storage area with a field reserved for the tire's serial number, and a method for storing the serial number in bit form. To achieve this, at least two allocated areas are required within the stored region to decode the tire's serial number. The binary values in the allocated areas must be converted to decimal, and within one of these areas, the decimal values must be converted to characters. Specifically, to generate the serial number, the area where the serial number is stored must be divided into at least two areas. Data retrieved from these areas must be processed individually, converted to decimal, and then matched to characters.

Ateq's US 11,279,183 B2 involves recording tire data using a separate tool to send pressure information and tire information from the vehicle's tire pressure monitoring sensor(TPMS). This data is stored in the TPMS and synchronized with the vehicle. However, the frequency used to record data in the electronic device differs from the frequency transmitted to the vehicle. This necessitated a separate frequency module within the tool. Furthermore, since tire data structure was not standardized for transmission when tire pressure measurement was the primary purpose, standardization proved difficult.

Additionally, since air pressure data must be included in the transmission, a manufacturer-specific software was required to extract the tire data alone.

Hufs US 11,161,377 B2 proposed a system and method for monitoring tire condition, but it did not reflect tire data standardization, making it difficult to address standardization requirements. Since air pressure data must be included in the transmission, a manufacturer-specific software was required to extract the tire data alone.

### <Prior Art documents>

Korean Patent Publication No. 10-2017-00664
Korean Patent No. 10-0715864
U.S. Patent No. 9,177,183 B2
U.S. Patent No. 11,279,183 B2
U.S. Patent No. 11,161,377 B2

### [DETAILED DESCRIPTION OF THE INVENTION]

### [TECHNICAL PROBLEM]

The object of the present invention to solve the above problems is to provide a technology that enables the identification of a tire's type even if the label attached to the tire is damaged, allows recognition even at distances where access is difficult due to tire loading, and facilitates the assignment and recognition of a unique number conforming to standard specifications.

Furthermore, the purpose of the present invention is to provide a tire data reading device and a data reading method therefor, enabling easy management of customer-specific tire information.

The technical problems addressed by the present invention are not limited to those described above and further include other problems that may be understood by a person skilled in the art from the descriptions of this specification.

### [SOLUTION TO PROBLEM]

An embodiment of the present invention for achieving the aforementioned objectives comprising, in a tire information management system for recording and reading tire information: an electronic device mounted on a tire and having a memory of 96 bits or more for recording tire information; an input device for inputting tire information into the memory of the electronic device; and a reading device for reading tire information input into the memory of the electronic device; wherein the memory stores tire company information, product information, and serial number information, thereby providing a tire information management system and a tire information management method using the same.

Furthermore, an embodiment of the present invention for achieving the purposes described above provides a tire wireless electronic device data reading device comprising: a recording module arranged to store identification information and tire information converted into binary form; and a restoration module to decrypt and restore the tire information stored in binary form in the recording module.

In an embodiment of the present invention, the recording module may comprise: an identification memory unit where the identification information containing the product code is stored; a tire memory unit where the tire information corresponding to the tire associated with the product code is stored; and a conversion unit arranged to convert the tire information into binary.

In an embodiment of the present invention, the conversion unit may be arranged to distinguish a numeric area and a character area in the tire information, converting the decimal number in the numeric area into binary, and sequentially converting the characters in the character area into decimal and binary.

### [ADVANTAGEOUS EFFECTS OF INVENTION]

According to an embodiment of the present invention with the above configuration, even if the label attached to the tire is damaged, the tire type can be identified. Recognition is possible even at distances where access to is difficult due to tire loading, and it facilitates the assignment and recognition of a standard-specification unique number.

Furthermore, when saved tire data differs by customer, it facilitates data management by identifying and restoring the structure of input data via the product code for display.

The effects of the present invention are not limited to the above effects and should be understood to include all effects inferable from the detailed description of the invention or the configuration of the invention described in the claims.

### [BRIEF DESCRIPTION OF THE DRAWINGS]

Fig. 1 shows an example of a tire ID according to international standards.
Fig. 2 is an explanatory diagram of a first embodiment of the tire information management system of the present invention.
Fig. 3 is a configuration diagram of a first embodiment of the tire information management system of the present invention.
Fig. 4 is an example of inputting a tire ID according to an international standard.
Fig. 5 is a configuration diagram of a data reading device of a wireless electronic device for tires according to a first embodiment of the present invention.
Fig. 6 is a flowchart of the data reading method of the data reading device of a wireless electronic device for tires according to an embodiment of the present invention.
Fig. 7 is a flowchart of the step of storing identification information and tire information according to a first embodiment of the present invention.
Fig. 8 is a flowchart of the step where extracted tire information is restored and provided to the user according to a first embodiment of the present invention.

### [BEST MODE]

The most preferred a first embodiment of the present invention, in a tire information management system for recording and reading tire information, comprising: an electronic device mounted on a tire and having a memory of 96 bits or more for recording tire information; an input device for inputting tire information into the memory of the electronic device; and a reading device for reading tire information input into the memory of the electronic device; wherein the memory stores tire company information, product information, and serial number information.

### [DESCRIPTION OF EMBODIMENTS]

Hereinafter, the present invention is described with reference to the accompanying drawings. However, the present invention may be modified in various different ways and is not limited to the embodiments described herein. Further, in the accompanying drawings, components irrelevant to the description will be omitted in order to clearly describe the present invention, and similar reference numerals will be used to describe similar components throughout the specification.

Throughout the specification, when an element is referred to as being "connected with(coupled to, combined with, in contact with)" another element, it may be "directly connected" to the other element and may also be "indirectly connected" to the other element with another element intervening therebetween. Further, unless explicitly described otherwise, "comprising" any components will be understood to imply the inclusion of other components rather than the exclusion of any other components.

Terms used in the present invention are used only in order to describe specific exemplary examples rather than limiting the present invention. Singular forms are intended to include plural forms unless the context clearly indicates otherwise. It will be further understood that the terms "comprise" or "have" used in this specification specify the presence of stated features, numerals, steps, operations, components, parts, or a combination thereof, but do not preclude the presence or addition of one or more other features, numerals, steps, operations, components, parts, or a combination thereof.

Terms '~er', '~unit', '~module', etc. used herein mean the units for processing at least one function or operation and may be implemented by hardware, software, or a combination of hardware and software.

Further, in the specification, when a step is positioned "before" or "after" another step, this includes the same right as not only when the step and another step are in a direct time-serial relationship, but when they are in an indirect time-serial relationship in which the orders of the two steps may be time-serially changed such as mixing of the steps after the steps.

Hereinafter, examples of the present invention are described in detail with reference to the accompanying drawings.

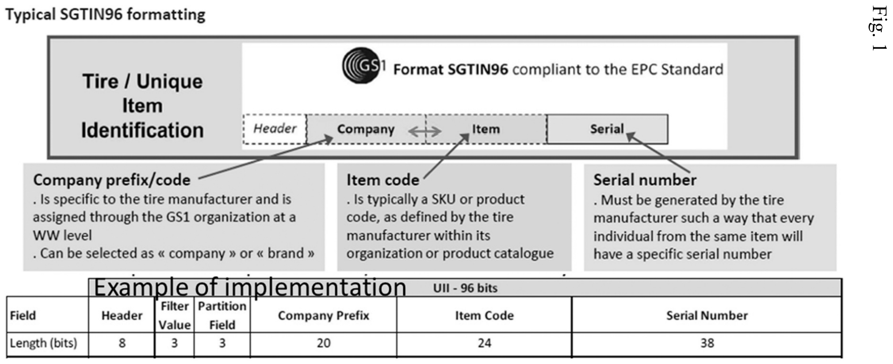

Fig. 1 shows an example of a tire ID according to international standards. As shown in Fig. 1, the label for tire information management displays product information and the tire serial number as the manufacturer's unique number. The ISO standard follows the format of GS1, an international private standards organization, and displays the unique number in binary form.

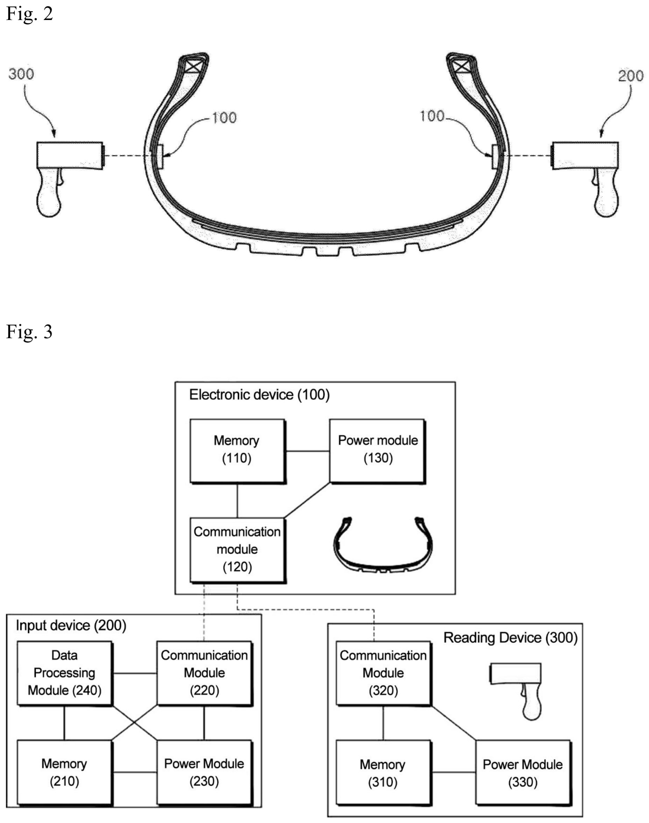

Fig. 2 is an explanatory diagram of a first embodiment of the tire information management system of the present invention, and Fig. 3 is a configuration diagram of an embodiment of the tire information management system of the present invention. To input and view the aforementioned information on the tire, the present invention relates to a tire information management system for recording and reading tire information, comprising: an electronic device(100) mounted on the tire and having a memory(110) of 96 bits or more for recording tire information; an input device(200) for inputting tire information into the memory(110) of the electronic device(100); a reading device(300) for reading tire information input into the memory(110) of the electronic device(100); thereby providing a tire information management system where the memory(110) stores tire company information, product information, and serial number information.

The electronic device(100) is preferably an RFID that receives information from an external source and stores it in the memory. An RFID system consists of an RFID tag combining a semiconductor chip and an antenna, an antenna for communicating with the tag, an RFID reader connected to the antenna, and a host that controls this system and processes the received data.

Accordingly, it is desirable that the electronic device(100), the input device(200), and the reading device(300) each include a communication module(120, 220, 320) for mutual communication. The communication module(220) of the input device(200) is connected to the host to receive information.

It may include respective power modules(130, 230, 330) for operating the electronic device(100). It is desirable that each of the respective power modules(130, 230, 330) be means capable of being charged by a battery or an external power source.

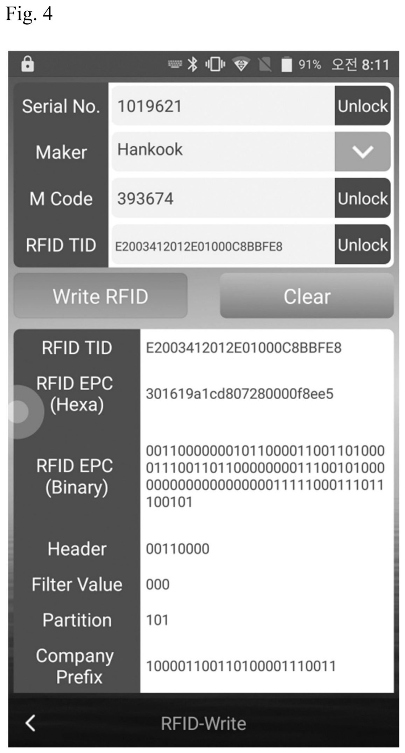

Fig. 4 is an example of inputting a tire ID according to an international standard. The input device(200) includes a data processing module(240). The data processing module(240) converts the serial number entered into the memory(210) of the input device(200) into binary. It automatically retrieves the Header, Filter Value, Partition information for the input data, arranging them at the front, and subsequently arranging the manufacturer information, product information, and serial number in binary to complete the full text.

The present invention further comprises: an electronic device(100) mounted on a tire and having a memory(110) of 96 bits or more for recording tire information; an input device(200) for inputting tire information into the memory(110) of the electronic device(100); a reading device(300) for reading tire information input into the memory(110) of the electronic device(100). The memory(110) stores tire company information, product information, serial number information. In a tire information management method for recording and reading tire information using a tire information management system, the method comprises: step(s100) of inputting manufacturer information, product information, and serial number into the memory(210) of the input device(200); a step(s200) of converting the serial number into binary; a step(s300) of automatically calling header, filter value, and partition information to arrange them at the front, then arranging subsequent company information, product information, and serial number in binary to complete the full text; a step(s400) of pairing the input device(200) with the electronic device(100) ; a step (s500) of inputting the full text into the memory(110) of the electronic device(100) via a communication module from the input device(200).

The step(s100) of inputting manufacturer information, product information, and a serial number into the memory(210) of the input device(200) involves the input device(200) connecting to a host at via a communication module(220) to receive the manufacturer information, product information, and serial number information and input it into the memory(210).

The manufacturer information is entered as characters or decimal numbers, typically using 6-8 decimal digits, preferably 7 decimal digits, and allocated 24 bits in binary.

Product information is entered as either a 6-digit decimal number or characters, corresponding to the product name designated by the tire manufacturer. When using a 6-digit decimal number, 20 bits are allocated in binary.

The serial number uses 10 decimal digits and is allocated 38 bits.

In step(s300), where the combined full text is completed by automatically calling the header, filter value, and partition information and arranging them at the front, followed by arranging the company information, product information, and serial number in binary, the resulting full text conforms to the international standard of 96 bits.

Furthermore, after the step(s500) where the full text is input from the input device(200) into the memory(110) of the electronic device(100), the present invention further comprises a step(s600) of reading by reading device(300) the full text from the memory(110) of the electronic device(100); a step(s700) of distinguishing manufacturer information, product information, and serial number, excluding the initially fixed input value bit count; a step(s800) of displaying the manufacturer information as characters; a step(s900) of displaying the product information as a decimal number; a step(s1000) of converting and displaying the serial number as a decimal number.

Meanwhile, after the step of displaying the product information as a decimal number(s900) among the distinguished information, it may include a step(s910) of displaying the product information as characters by matching the decimal number to a prepared character conversion table so that it matches the number of the product information displayed as a decimal number.

According to the above-described embodiment of the present invention, even if the label attached to the tire is damaged, the tire type can be identified. Recognition is possible even at distances where access is difficult due to tire loading, and it has the effect of easily assigning and recognizing a standard-specification unique number.

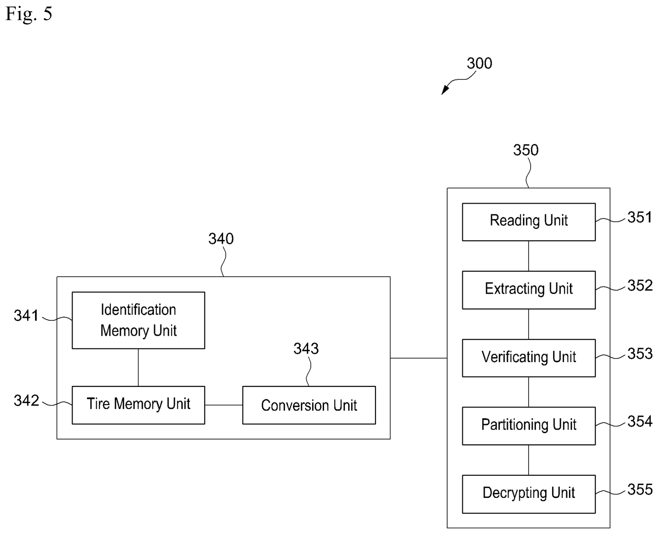

Fig. 5 is a configuration diagram of a data reading device of a wireless electronic device for tires according to an embodiment of the present invention.

Referring to Fig. 5, the wireless electronic device data reading device(300) for tires may include a recording module(340) and a restoration module(350).

The recording module(340) may store identification information and tire information converted into binary code.

The recording module(340) may include an identification memory unit(341), a tire memory unit(342), and a conversion unit(343). However, the number of memory units included in the recording module(340) is not limited to these, and additional units may be provided depending on the distinct memory areas.

The identification memory unit(341) may store the identification information.

Here, the identification information includes the tire ID, and the tire ID may include a product code.

The tire memory unit(342) may be provided to store the tire information corresponding to the tire associated with the product code.

Here, the tire information may include tire-related information that a customer may request. For example, the tire information may include information such as tire specifications, replacement cycle, year of manufacture, and year of purchase.

The identification memory unit(341) and the tire memory unit(342) may have different data structures.

The conversion unit(343) may convert the tire information into binary code.

Specifically, the conversion unit(343) can distinguish between a numeric area and a character area within the tire information. Furthermore, the conversion unit(343) may convert decimal numbers in the numeric area to binary numbers, and in the character area, to first convert characters to decimal numbers and then sequentially convert the converted decimal numbers to binary numbers.

The tire memory unit(342) may store the tire information in a state where the decimal numbers and characters have been converted into binary by the conversion unit(343).

The tire memory unit(342) may store the tire information in a state where the decimal numbers and characters have been converted into binary by the conversion unit(343).

The restoration module(350) may include a reading unit(351), an extracting unit (352), a verificating unit(353), a partitioning unit(354), and a decrypting unit(355).

The reading unit(351) may retrieve and read the identification information stored in the identification memory unit(341).

The extracting unit (352) may extract the tire information corresponding to the identification information read by the reading unit(351) from the tire memory unit(342).

The verificating unit(353) may verify the user by matching the identification information with the tire information. For example, the verificating unit(353) may verify whether the user who entered the identification information is the customer, and to verify whether the product code included in the identification information matches the tire information, etc.

The partitioning unit(354) may identify the structure of the numeric area and character area in the tire memory unit(342), and then separate the numeric area and character area of the extracted tire information.

The decrypting unit(355) may be configured to convert the binary numbers stored in the numeric area separated by the partitioning unit(354) back into their original decimal form.

Furthermore, the decrypting unit(355) may first convert the binary numbers stored in the character area into decimal numbers. Then, the decrypting unit(355) may match the converted decimal numbers with characters to convert them back into characters.

The restoration module(350) may provide the tire information, converted to the original decimal values and characters, to the user. For this purpose, the restoration module(350) may further include a display unit(not shown), such as a monitor.

Meanwhile, the identification memory unit(341) and the tire memory unit(342) may each be composed of a single or multiple memory areas.

For example, in the case of RFID, it may be divided into four memory areas. Among these, tire-related information may be stored in the EPC memory area, which stores the tire ID, and in the user memory area, where the tire manufacturer records additional information. However, since the user memory area is not a mandatory area for the tire ID, it can store different data and formats depending on the manufacturer or customer.

The following describes the data reading method for the data reading device of a wireless electronic device for tires.

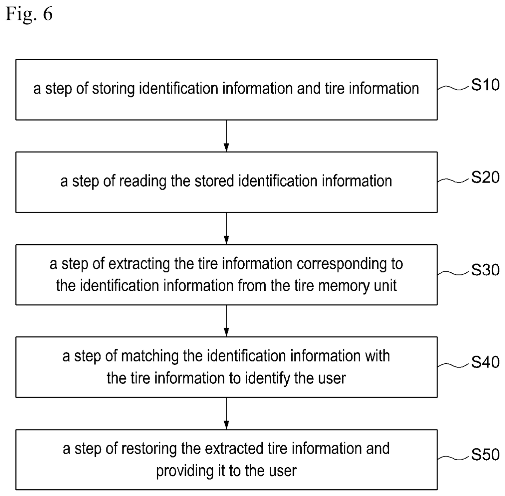

Fig. 6 is a flowchart of the data reading method for the tire wireless electronic device data reading device according to an embodiment of the present invention.

Referring to Fig. 6, the data reading method for the tire wireless electronic device data reading device comprises: a step(S10) of storing identification information and tire information; a step(S20) of reading the stored identification information; extracting tire information corresponding to the identification information from the tire memory unit(S30), matching the identification information with the tire information to identify the user(S40), and restoring the extracted tire information and providing it to the user(S50).

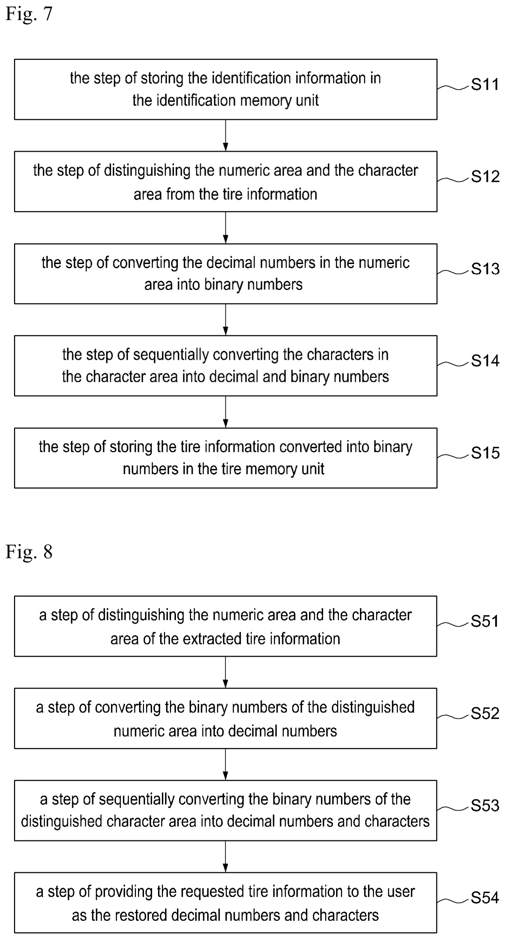

Fig. 7 is a flowchart of the steps for storing identification information and tire information according to an embodiment of the present invention.

First, referring to Fig. 7, the step(S10) where identification information and tire information are stored comprises: the step(S11) where identification information is stored in the identification memory unit; the step(S12) where the numeric area and character area are distinguished within the tire information; converting the decimal numbers in the numeric area to binary numbers(S13), sequentially converting the characters in the character area to decimal and binary numbers(S14), and storing the tire information converted to binary numbers in the tire memory unit(S15).

In the step of storing identification information in the identification memory unit(S11), the identification information may be stored in the identification memory unit(341). Here, the identification information includes a tire ID, and the tire ID may include a product code.

Next, in the step(S12) of distinguishing the numeric area and character area within the tire information, the conversion unit(343) may distinguish the numeric area and character area from the tire information.

Next, in the step(S13) where the decimal numbers in the numeric area are converted to binary, the conversion unit(343) can convert the decimal numbers in the numeric area to binary.

Next, in the step(S14) where characters in the character area are sequentially converted into decimal and binary, the conversion unit(343) can first convert the characters in the character area into decimal and then sequentially convert the resulting decimal values back into binary.

In the step(S15) where the tire information converted into binary is stored in the tire memory unit(342), the tire memory unit(342) may be arranged to store the decimal numbers and characters, each converted into binary by the conversion unit(343).

Referring again to Fig. 6, next, in the step of reading the stored identification information(S20), the reading unit(351) may retrieve and read the identification information stored in the identification memory unit(341). At this time, the reading unit(351) may read the product code of the tire's ID from the identification information.

In the step of extracting tire information corresponding to the identification information from the tire memory unit(S30), the extracting unit (352) may extract the tire information corresponding to the identification information read by the reading unit(351) from the tire memory unit(342).

Next, in the step of matching the identification information with the tire information to identify the user(S40), the verificating unit(353) may identify the user by matching the identification information with the tire information. For example, the verificating unit(353) may verify whether the user who entered the identification information is the customer, and to verify whether the product code included in the identification information matches the tire information, etc.

Fig. 8 is a flowchart of the steps for restoring extracted tire information and providing it to the user according to an embodiment of the present invention.

Referring to Fig. 8, the step(S50) of restoring the extracted tire information and providing it to the user comprises: a step(S51) of distinguishing the numeric area and the character area of the extracted tire information; converting the binary numbers of the distinguished numeric area into decimal numbers(S52), sequentially converting the binary numbers of the distinguished character area into decimal numbers and characters(S53), and providing the requested tire information to the user using the restored decimal numbers and characters(S54).

First, in the step of distinguishing the numeric area and character area of the extracted tire information(S51), the partitioning unit(354) may identify the structure of the numeric area and character area in the tire memory unit(342), and then distinguish the numeric area and character area of the extracted tire information.

Next, in step(S52) where the binary numbers of the distinguished numeric area are converted to decimal, the decrypting unit(355) may first convert the binary numbers stored in the character area to decimal.

Next, in the step(S53) of sequentially converting the binary of the distinguished character area into decimal and then into characters, the decrypting unit(355) may first convert the binary in the character area into decimal numbers and then convert the decimal numbers into characters by matching them to characters.

In the step(S54) of providing requested tire information to the user as restored decimal numbers and characters, the restoration module(350) may provide to the user the tire information converted back into the original decimal numbers and characters as described above.

Thus, the present invention facilitates data management by identifying and restoring the structure of input data via the product code and displaying it, even when customer-specific tire storage data differs.

Although certain embodiments and implementations have been described herein, other embodiments and modifications will be apparent from this description. Accordingly, the inventive concepts are not limited to such embodiments, but rather to the broader scope of the appended claims and various obvious modifications and equivalent arrangements as would be apparent to a person of ordinary skill in the art. Therefore, the true technical protection scope of the present invention should be determined by the technical idea of the appended claims.

### < Reference Signs>

100: Electronic device
110: Memory
120: Communication module
130: Power module
200: Input device
210: Memory
220: Communication Module
230: Power Module
240: Data Processing Module
300: Reading Device
310: Memory
320: Communication Module
330: Power Module
340: Recording Module
341: Identification Memory Unit
342: Tire Memory Unit
343: Conversion Unit
350: Restoration Module
351: Reading Unit
352: Extracting Unit
353: Verificating Unit
354: Partitioning Unit
355: Decrypting Unit

## Claims

1. A tire information management system for recording and reading tire information comprising:
an electronic device mounted on the tire and having a memory of 96 bits or more for recording tire information;
an input device for inputting tire information into the memory of the electronic device; and
a reading device for reading tire information input into the memory of the electronic device;
wherein the memory stores tire company information, product information, and/or a serial number information.

2. A tire information management system of claim 1,
wherein the electronic device, the input device, and the reading device each include a communication module for mutual communication.

3. A tire information management system of claim 2,
wherein the input device has a data processing module,
wherein the data processing module converts the serial number input into the memory of the input device into binary, and automatically calls the Header, Filter Value, and Partition information for the input information, and arranges them at the front, and subsequently arranges the manufacturer information, product information, and serial number in binary to complete a full text.

4. A tire information management method for recording and reading a tire using a tire information management system of claim 1, the method comprising:
a step(s100) of inputting manufacturer information, product information, and serial number into the memory of the input device;
a step(s200) of converting the serial number into binary;
a step(s300) of automatically calling Header, Filter Value, and Partition information for the input data, arranging them at the front, and subsequently arranging company information, product information, and serial number in binary to complete a full text;
a step(s400) of pairing the input device with the electronic device; and
a step(s500) of inputting the full text from the input device into the memory of the electronic device through a communication module.

5. A tire information management method of claim 4,
after the step(s500) of inputting the full text from the input device into the memory of the electronic device,
a step(s600) of reading by the reading device the full text from the memory of the electronic device;
a step(s700) of distinguishing manufacturer information, product information, and serial number, excluding the initially fixed input bitnumber;
a step(s800) of displaying the manufacturer information among the distinguished information as characters;
a step(s900) of displaying the product information among the distinguished information as in decimal number; and
a step(s1000) of converting and displaying the serial number among the distinguished information as in decimal number.

6. A tire information management method of claim 5,
after the step(s900) of displaying the product information among the distinguished information as in decimalnumber,
a step(s910) of displaying the product information as characters by matching the decimal number to a character conversion table prepared to match the number of the product information displayed as in decimal number.

7. A tire information management system of claim 1,
the reading device comprising:
a recording module arranged to store identification information and tire information converted into binary; and
a restoration module arranged to decode and restore the tire information stored in binary form in the recording module.

8. A tire information management system of claim 7,
the recording module comprising:
an identification memory unit where the identification information including the product code is stored;
a tire memory unit where the tire information corresponding to the product code is stored; and
a conversion unit to convert the tire information into binary form.

9. A tire information management system of claim 8,
wherein the conversion unit is configured to distinguish a numeric area and a character area in the tire information, convert the decimal numbers to binary numbers in the numeric area, and sequentially convert the characters to decimal numbers and binary numbers respectively in the character area.

10. A tire information management system of claim 9,
the restoration module comprising:
a reading unit to read the identification information stored in the identification memory unit;
an extracting unit to extract the tire information corresponding to the identification information read by the reading unit from the tire memory unit;
a verificating unit to verify the user by matching the identification information with the tire information;
a partitioning unit to separate the numeric area and the character area of the extracted tire information; and
a decrypting unit to convert the numeric area separated by the partitioning unit into decimal numbers and to sequentially convert the character area into decimal numbers and characters.

11. A data reading method of the tire information management system of claim 10, comprising:
a step of storing the identification information and the tire information;
a step of reading the stored identification information;
a step of extracting the tire information corresponding to the identification information from the tire memory unit;
a step of matching the identification information with the tire information to identify the user; and
a step of restoring the extracted tire information and providing it to the user.

12. A data reading method of the tire information management system of claim 11,
the step of storing the identification information and the tire information comprising:
a step of storing the identification information in the identification memory unit;
a step of distinguishing the numeric area and the character area from the tire information;
a step of converting the decimal numbers in the numeric area into binary numbers;
a step of sequentially converting characters in the character area into decimal and binary numbers; and
a step of storing the tire information converted into binary numbers in the tire memory unit.

13. A data reading method of the tire information management system of claim 11,
the the step of reading the stored identification information comprising:
reading the product code.

14. A data reading method of the tire information management system of claim 11,
the step of restoring the extracted tire information and providing it to the user comprising:
a step of distinguishing the numeric area and the character area of the extracted tire information;
a step of converting the binary numbers in the distinguished numeric area into decimal numbers;
a step of sequentially converting the binary numbers of the distinguished character area into decimal numbers and characters; and
a step of providing the requested tire information to the user as the restored decimal numbers and characters.
